# EUROPEAN PATENT APPLICATION

(11) **EP 2 043 169 A2**
(43) Date of publication of application: **01.04.2009**
(21) Application number: 08016985.7
(22) Date of filing: 26.09.2008
(51) Int. Cl.: H01L 35/32

(54) **Thermoelectric module substrate and thermoelectric module using such substrate**

(30) Priority: 28.09.2007 JP 2007253875
(71) Applicant: YAMAHA CORPORATION, Naka-Ku Hamamatsu-shi, Shizuoka-ken (JP)
(72) Inventor: Horio, Yuma, Hamamatsu-Shi Shizuoka-Ken (JP)
(74) Representative: Emde, Eric

(57) **Abstract**

To obtain a thermoelectric module substrate of which reliability such as stress relaxation is improved without damaging the performance as a thermoelectric module such as heat conductivity to provide a thermoelectric module excellent in reliability by using such a substrate. Thermoelectric module substrates of the present invention each comprises a synthetic resin layer including fillers having good thermal conductivity; and a copper-metalized layer or layers, or a copper layer at least including copper plate or copper layers which is or are formed on one face or both faces of the synthetic resin layer. Further, in the case where contents volume percentage of fillers within the synthetic resin layer is expressed as A (%), the thickness of the synthetic resin layer is expressed as B (µm) and the total thickness of the copper layer is expressed as C (µm), the thermoelectric module substrate is formed so as to have the relation expressed as (C/4) - B ≤ 65, A/B ≤ 3.5, A > 0, C > 50 and B ≥ 7.

## Description

### BACKGROUND OF THE INVENTION

### Field of the invention

The present invention relates to a thermoelectric module substrate including: a synthetic resin layer including fillers having satisfactory thermal conductivity; and a copper metalization layer or a copper layer constituted from a copper plate formed on one or both faces of this synthetic resin layer, and in addition, the present invention relates to a thermoelectric module using the thermoelectric module substrate.

### Description of Related Art

Hitherto, there are widely known thermoelectric modules which has a constitution in which thermoelectric elements formed of P-type semiconductor and thermoelectric elements formed of N-type semiconductor are alternately arranged so that the respective thermoelectric elements are adjacent and the respective thermoelectric elements are disposed between an upper substrate where a wiring pattern for a thermoelectric element is formed and a lower substrate where a thermoelectric element wiring pattern is formed in such a manner that they are electrically conductively connected to each other in series. However, in such thermoelectric module of this kind, in general, a substrate (upper substrate and lower substrate) such as ceramic having an electric insulating property is used. For this reason, the part where endothermic surface or an exothermic surface is attached is limited to a solid plane surface. For example, there was a problem in that the attachment is not made with respect to, e.g., a part where the external shape is a curved surface.

In view of the above, in the Patent Document 1 (Japanese Patent Application, First Publication No. H07-202275) and the Patent Document 2 (Japanese Patent Application, First Publication No. H08-228027), there have been proposed thermoelectric modules in which a synthetic resin substrate having flexibility is used in order that the endothermic surface or the exothermic surface can be freely deformed, and thermoelectric elements are electrically conductively connected to the synthetic resin substrate through conductive layers in such a manner that they are electrically conductively connected to each other in series. Here, in the thermoelectric module proposed in the Patent Document 1, Peltier effect elements (thermoelectric elements) are arranged at a thin copper belt formed at a thin plate of a resin having heat-resistance and flexibility in such a manner that they are arranged with a predetermined spacing therebetween, and are welded thereto by solder.

On the other hand, in the Patent Document 2, p-type semiconductor crystals for thermoelectric element and n-type semiconductor crystals for thermoelectric element which are the same in the number thereof are caused to be cross-linked by a soft insulating material or a hard insulating material so that there results thermoelectric module having flexibility. In this case, as an insulating material, there is used rubber, plastics, silicon resin, etc.

However, in the thermoelectric module as disclosed in the above-described Patent Document 1, since thermal conductivity of a synthetic resin layer serving as a substrate is low, there took place a problem in that the maximum calorific value (Qmax) which constitutes important performance in this thermoelectric module is lowered.

On the other hand, in the thermoelectric module as disclosed in the above-described Patent Document 2, since an insulating material having low heat conductivity exists between upper and lower substrates (these upper and lower substrates respectively serve as an exothermic side substrate and an endothermic side substrate), there took place the problem that it becomes difficult to obtain a temperature difference (ΔT) between upper and lower substrates which exhibits important characteristic with respect to heat conduction.

Here, in the case where a synthetic resin is used as a base material of a substrate, as the thickness of a synthetic resin layer becomes thick, the maximum calorific value (Qmax) which is important performance with respect to the thermoelectric module is lowered to thus lower the performance of the thermoelectric module. In contrast, when the thickness of the synthetic resin layer is caused to be too thin, relaxation effect of stress which is a primary object for the synthetic resin substrate is decreased so that the reliability of the thermoelectric module would be lowered. In this case, if fillers having good thermal conductivity, such as ceramics, are dispersed within the synthetic resin layer to thus improve heat conductivity of the synthetic resin layer, it can be predicted as a matter of course that maximum thermoelectric calorific value (Qmax) can be improved so that a thermoelectric module having excellent reliability would be obtained.

Meanwhile, as a result of studying by the inventors of the present invention, in the case where fillers having good heat conductivity are dispersed within a synthetic resin layer, if an additive ratio (volume ratio) of the fillers is too large, the rigidity of the synthetic resin layer would be increased. For this reason, the inventors have found that a stress relaxation effect caused by the synthetic resin is deteriorated so that the reliability of a thermoelectric module is lowered. On the other hand, they have also found that the thickness of a copper metalization layer or copper layer constituted from a copper plate which is formed on a surface of the synthetic resin layer is greatly affected by the performance and the reliability of the thermoelectric module.

### SUMMARY OF THE INVENTION

In view of the above, the present invention has been made on the basis of the findings as described above, and has found a specific relationship between the thickness of a synthetic resin layer, the addition percentage (volume ratio) of fillers added in a dispersed state within the synthetic resin layer, and the thickness of copper layer formed on the surface of the synthetic resin layer to optimize these three parameters. Thus, an object of the present invention is to obtain a thermoelectric module substrate having improved reliability such as stress relaxation without damaging the performance thereof as a thermoelectric module, for example, heat conductivity, to thus have ability to provide a thermoelectric module excellent in reliability by using such a substrate.

A thermoelectric module substrate of the present invention includes; a synthetic resin layer containing fillers having satisfactory thermal conductivity; and a copper metalized layer or a copper layer constituted from a copper plate which is formed on one or both faces of the synthetic resin layer. Further, in order to attain the above object, in the case where contents volume percentage of fillers within the synthetic resin layer is expressed as A (vol %), the thickness of the synthetic resin layer is expressed as B (µm), and the total thickness of the copper layer is expressed as C (µm), the relationship expressed as (C/4)-B≤65, A/B≤3.5, A > O, C > 50, and B≥7 are maintained.

Here, when fillers having satisfactory thermal conductivity are dispersed within synthetic resin layer (A > O), heat conductivity of synthetic resin layer is improved. However, when contents volume percentage of filler is too large, the rigidity of the synthetic resin layer is increased so that stress relaxation effect as synthetic resin substrate would be lowered. However, when ratio (A/B) of contents volume percentage A (vol %) of fillers with respect to B(µm) of synthetic resin layer is 3.5 or less (A/B≤3.5 vol % / µm), it has been clear that the reliability is improved without lowering stress relaxation effect.

Moreover, according as total thickness C (µm) of copper layer or copper layers formed on one face or both faces of the synthetic resin layer is increased, electric resistance value as electrode of junction to the thermoelectric element is decreased, and heat conductivity and heat uniformness at a junction part (exothermic part and endothermic part) to a temperature-controlled body is improved. On the other hand, according as total thickness C (µm) of the copper layer becomes large, relaxation effect of stress as a substrate is decreased. As a result, the reliability as the thermoelectric module would be lowered. However, it has been found that when the difference between 1/4 of the total thickness C (µm) of the copper layer and thickness B (µm) of the synthetic resin layer is 65 µm is or less, relaxation effect of stress is exhibited.

Here, when total thickness C (µm) of the copper layer or layers formed on one face or both faces of the synthetic resin layer is thicker than 50 µm (C > 50), heat conductivity as substrate and heat uniformity at a junction (exothermic part and endothermic part) to a temperature-controlled body are ensured. Moreover, according as the thickness B (µm) of the synthetic resin layer in which fillers are dispersed becomes thin, the thermal conductivity is improved to more degree. However, when the thickness is caused to be thin, Joule heat would be produced. As a result, the reliability as the thermoelectric module would be lowered. In this case, it has been clear that if the thickness B (µm) of the synthetic resin layer is 7 µm or more (B ≥ 7), the reliability is improved. On the other hand, when the thickness B (µm) of the synthetic resin layer in which fillers have been dispersed is thick, the substrate has high rigidity. As a result, relaxation effect of stress of the substrate is decreased. Accordingly, it is desirable that the maximum value of thickness B of the synthetic resin layer is set to approximately 30 µm.

In view of the above-mentioned matters in total, in the present invention, in the case where contents volume percentage of fillers within the synthetic resin layer is exprssed as A (vol %), the thickness of the synthetic resin layer is expressed as B (µm) and total thickness of copper layer is expressed as C (µm), there is caused to hold the relation expressed as (C/4) - B≤65, A/B≤3.5, A>0, C>50 and B≥7. In this case, it is desirable that synthetic resin is either polyimide resin or epoxy resin. In addition, it is preferable that filler having satisfactory heat conductivity is selected from a group consisting of alumina, aluminum nitride, magnesium oxide and carbon, and at least one kind of these fillers is added in a dispersed state within synthetic resin layer.

It is to be noted that in the case where carbon as filler is graphite or carbon nanotube (CNT), it is required to disperse such graphite or carbon nanotube (CNT) so that it does not exist within the range of 5% of total thickness of the synthetic resin layer from both surfaces of the synthetic resin layer. This is because since graphite or carbon nanotube (CNT) is excellent in electric conductivity, when such graphite or carbon nanotube (CNT) is dispersed up to the surface of the synthetic resin layer, such material electrically conducts copper layer formed on one surface of the synthetic resin layer so that it would not function as thermoelectric module substrate.

In the thermoelectric module substrate of the present invention, in order to improve heat conductivity which is defect of the synthetic resin substrate which exhibits stress relaxation effect, fillers having satisfactory thermal conductivity are added in dispersed state within the synthetic resin layer. Further, in order to prevent lowering of reliability due to dispersion and/or addition of fillers, optimization is made such that thickness of synthetic resin layer, volume ratio of fillers within synthetic resin layer, and copper layer formed on the surface of the synthetic resin layer are caused to have a specific relation. Thus, it is possible to provide a thermoelectric module in which high module performance and high reliability are compatible.

### BRIEF DESCRIPTION OF THE DRAWINGS

FIG. 1A and B are a view showing, in a model form, a thermoelectric module substrate of the present invention, wherein FIG. 1A is a back side view showing, in a model form, the essential part of the back side of an upper substrate, and FIG. 1B is a top view showing, in a model form, the essential part of an upper surface of a lower substrate.

FIG. 2 is a cross sectional view showing, in a model form, the cross section of the essential part of the thermoelectric module formed by using the upper substrate and the lower substrate shown in FIG. 1A and B.

### DETAILED DESCRIPTION OF THE INVENTION

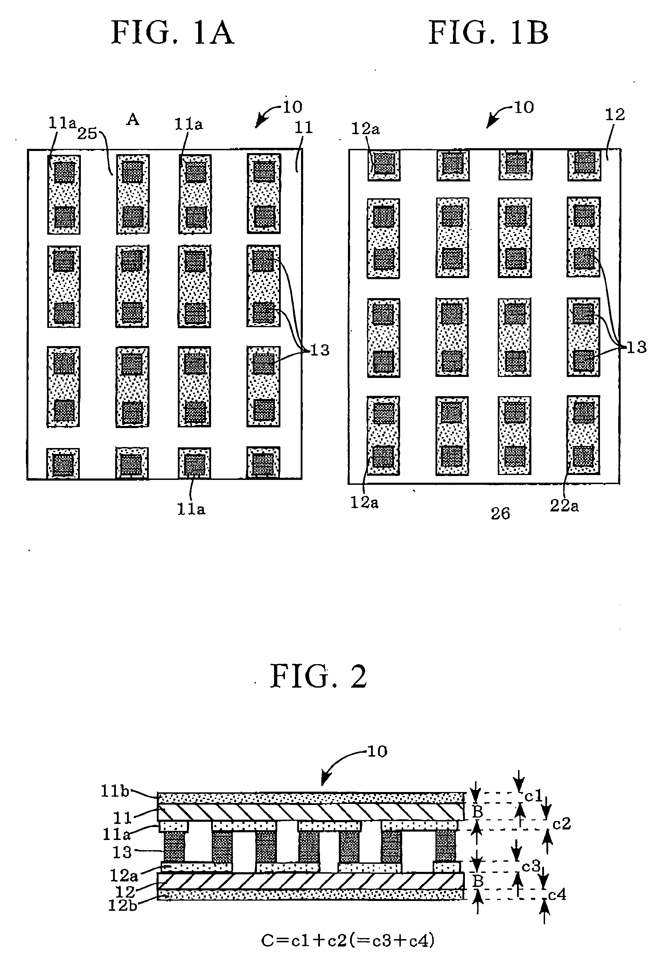

While preferred embodiments of a thermoelectric module substrate and a thermoelectric module using such a substrate of the present invention will now be described, the present invention is not limited to such embodiments by any means, but can be implemented after suitably changed within the range which does not depart from the object of the invention. Here, FIG. 1A and 1B are a view showing, in a model form, thermoelectric module substrate of the present invention, wherein FIG. 1A is a back side view showing, in a model form, the essential part of the back side of an upper substrate (the state where thermoelectric elements are disposed is shown in a model form), and FIG 1B is a top view showing, in a model form, the essential part of an upper surface of a lower substrate (the state where thermoelectric elements are disposed is shown in a model form). FIG. 2 is a cross sectional view showing, in a model form, the cross section of the essential part of the thermoelectric module formed by using the upper substrate and the lower substrate shown in FIG. 1A and 1B,

A preferred embodiment of a thermoelectric module substrate of the present invention includes a synthetic resin layer into which fillers having good thermal conductivity are dispersed, and a copper metalized layer or a copper layer at least including a copper plate formed on one face of the synthetic resin layer, copper metalized layers or copper layers each at least including a copper plate respectively formed on both faces thereof, wherein in the case where contents volume percentage of the fillers within the synthetic resin layer is expressed as A (vol%), the thickness of the synthetic resin layer is expressed as B (µm), and total thickness of the copper layer is expressed as C(µm), there hold the relation expressed as (C/4) - B≤65(µm), A/B≤3.5 (vol%/µm), A>0, C> 50(µm) and B≥7 (µm).

Another preferred embodiment of the present invention is directed to a thermoelectric module using the above-mentioned thermoelectric module substrate, wherein the thermoelectric module substrate in which a metallic layer formed on a reverse surface serves as a wiring pattern for thermoelectric element is caused to be an upper substrate, the thermoelectric module substrate in which a metallic layer formed on an obverse surface serves as a wiring pattern for thermoelectric element is caused to be a lower substrate, and a plurality of thermoelectric elements are disposed and fixed so that they are connected in series between the thermoelectric element wiring patterns of these both substrates.

These preferred embodiments will be implemented in practice by examples described below.

### 1 Example 1

A synthetic resin layer serving as a thermoelectric module substrate of this example 1 is formed by polyimide resin having electric insulating property, and is formed in a film shape so that thickness (B) of synthetic resin layer falls within a range from 7 µm to 30 µm (7 µm ≤ B ≤ 30 µm) of the synthetic resin layer. The synthetic resin layer is adapted to constitute an upper substrate 11 as shown in FIG 1A and a lower substrate 12 as shown in FIG. 1B. In this example, in order to improve thermal conductivity of polyimide resin, fillers at least including alumina powder (average grain diameter is 15 µm or less) are added in a dispersed state. Further, the upper substrate 11 is cut and has a shape in which, for example, the substrate size is 40 mm (width) × 40 mm (length). In addition, the lower substrate 12 to which lead wires (not shown) are attached is cut and has a shape in which, for example, the substrate size is 40 mm (width) × 45 mm (length).

In this case, thermoelectric element wiring pattern (copper film) 11 a is formed on the lower surface of the upper substrate 11, and connection copper film 11b is formed so as to substantially cover the entire surface of the upper surface thereof. On the other hand, thermoelectric element wiring pattern (copper film) 12a is formed on the upper surface of the lower substrate 12, and a connection copper film 12b is formed so as to substantially cover the entire surface of the lower surface thereof. In this example, the thermoelectric element wiring patterns 11a, 12a are formed so as to take a predetermined wiring pattern with a predetermined thickness (c2 = c3) by, e.g., copper plating method, DBC (Direct Bonding Copper) method, or brazing method etc. Moreover, similarly, the connecting copper films 11b, 12b are also formed so as to have a predetermined thickness (c1 = c4) by the copper plating method, the DBC (Direct Bonding Copper) method and the brazing method, etc.

Further, in the thermoelectric module 10 using the upper substrate 11 and the lower substrate 12 including the above-described polyimide resin film, a large number (120 pairs in this example) of thermoelectric elements 13 are disposed and connected so that they are electrically connected in series between the above-described both wiring patterns (copper films) 11a, 12a. In this case, the thermoelectric element 13 is configured to include P-type semiconductor compound element and N-type semiconductor compound element which are formed so as to have sizes of 2 mm (length) × 2 mm (width) × 1.4 mm (height). Further, these thermoelectric elements 13 are soldered by solder consisting of SnSb alloy, SnAu alloy or SnAgCu alloy respectively with respect to thermoelectric element wiring pattern 11a formed on the upper substrate 11 and thermoelectric element wiring pattern 12a formed on the lower substrate 12.

It is to be noted that it is desirable to use sintered body consisting of Bi-Te (Bismuth-Tellium) based thermoelectric material which exhibits high performance at a room temperature as thermoelectric element 13, and it is preferable to use material consisting of three elements of Bi-Sb-Te as P-type semiconductor compound element, and it is preferable to use material consisting of four elements of Bi-Sb-Te-Se as N-type semiconductor compound element. In concrete terms, an element having composition represented by Hi_{0.5}Sb_{1.5}Te₃ was used as P-type semiconductor compound element, an element having composition represented by Bi_{1.9}Sb_{0.1}Te_{2.6}Se_{0.4} was used as N-type semiconductor compound element, and an element formed by hot press sintering method was used.

Here, in the case where contents volume percentage of fillers existing within synthetic resin layers of the upper substrate 11 and the lower substrate 12 is expressed as A (vol %), each thickness of synthetic resin layers of the upper substrate 11 and the lower substrate 12 is exprssed as B (µm), and total thickness of copper layers consisting of wiring pattern (copper film) 11a and connecting copper film 11b (or wiring pattern (copper film) 12a and connecting copper film 12b) is expressed as C (C = c1 + c2 = c3 + c4) µm, there was fabricated a thermoelectric module in which each thicknesses of synthetic resin layers of upper substrate 11 and lower substrate 12 is fixed to 20 µm (B = 20 µm), ratio A/B (vol% /µm) having contents volume percentage of fillers with respect to thicknesses of synthetic resin layers of these substrates 11, 12 is fixed to 2.0 (vol % /µm).

In this case, a module formed such that the total thickness C (µm) of the metallic layer is changed so that (C/4) - B becomes equal to 0µm is designated as thermoelectric module PA11. Similarly, a module formed such that (C/4) - B becomes equal to 5 µm is designated as thermoelectric module PA12, a module PA13 formed such that (C/4) - B becomes equal to 19 µm is designated as PA 13, a module formed such that (C/4)-B becomes equal to 38 µm is designated as the thermoelectric module PA14, a module formed such that (C/4)-B becomes equal to 55 µm is designated as thermoelectric module PA 15, a module formed such that (C/4) - B becomes equal to 65 µm is designated as thermoelectric module PA 16, and a module formed such that (C/4) - B becomes equal to 70 µm is designated as thermoelectric module PA 17.

### (Performance evaluation and evaluation of reliability of thermoelectric module)

When maximum temperature difference (ΔT max) and maximum endothermic quantity (Q max) of these respective thermoelectric modules PA11 to PA17 are respectively determined in vacuum by using the thermoelectric modules PA11 to PA17 which have been fabricated as described above, results as shown in the following Table 1 were obtained. In this case, at the time of measuring maximum temperature difference (ΔT max), temperature of the endothermic side is maintained so that it becomes equal to a predetermined temperature of 27°C. Moreover, ACR change rates (change rates ofA.C. resistance) serving as index of reliability (stress relaxation) of these respective thermoelectric modules PA 11 to PA 17 were determined in a manner described below. In this case, there are first performed, by 5000 cycles, temperature cycles to elevate temperatures of the upper part and the lower part of the thermoelectric modules PA11 to PA 17 for two minutes from 0K to 150K to maintain this temperature for one minute thereafter to lower temperature for three minutes from 150K to 0K. Next, when A.C. resistance values (ACRs) of respective thermoelectric modules PA11 to PA17 are measured after 5000 cycles to determine ratio (change rate) with respect to ACR before temperature cycle, results as shown in the following Table 1 were determined, Further, ratios with respect to the obtained ACR (ACR change rate) were evaluated as index of reliability (stress relaxation).

**Table 1**

| Modules | Resin Material | Filler | (C/4)-B (µm) | A/B (vol%/µm) | ΔTmax (°C) | Qmax (W) | ACR Change Rate |
|---|---|---|---|---|---|---|---|
| PA11 | Polyimide | Alumina | 0 | 2.0 | 71 | 202 | 1. 2 |
| PA12 | Polyimide | Alumina | 5 | 2.0 | 70 | 202 | 1. 3 |
| PA13 | Polyimide | Alumina | 19 | 2. 0 | 71 | 204 | 1.2 |
| PA14 | Polyimide | Alumina | 38 | 2.0 | 70 | 205 | 1.4 |
| PA15 | Polyimide | Alumina | 55 | 2.0 | 69 | 202 | 1.8 |
| PA16 | Polyimide | Alumina | 65 | 2.0 | 69 | 203 | 1. 9 |
| PA17 | Polyimide | Alumina | 70 | 2.0 | 69 | 206 | 6. 7 |

As apparent from the results of the above Table 1, it is understood that considerable difference cannot be observed at thermoelectric modules PA11 to PA17 with respect to the maximum temperature difference (ΔT max) and maximum endothermic quantity (Qmax). On the other hand, it is understood that when (C/4) - B, i.e., difference between thickness of 1/4 of total thickness of copper layer and thickness of resin layer becomes equal to 70 µm, the ACR change rate is abruptly raised so that reliability (stress relaxation) of the thermoelectric module PA 17 is lowered. From this fact, it is understood that in the case where there are used upper substrate 11 and lower substrate 12 in which resin material into which alumina powder is added as filler is formed of polyimide resin, when wiring pattern (copper film) 11a, connecting copper film 11b, wiring pattern (copper film) 12a, and connecting copper film 12b are formed so that (C/4) - B becomes equal to 65 µm or less, thermoelectric modules PA11 to PA16 of which reliability has been improved can be obtained.

Next, there was fabricated a thermoelectric module in which each thickness of synthetic resin layers of the upper substrate 11 and the lower substrate 12 is fixed to 15 µm (B = 15 µm), total thickness C (µm) of the metallic layer is fixed to 240 (µm), and (C/4) - B is fixed to 45 µm. In this case, a module formed such that ratio A/B (vol % / µm) of contents volume percentage of fillers with respect to the thickness of synthetic resin layer of these substrates is changed so that A/B becomes equal to 0.5 vol % / µm is designated as thermoelectric module PA21. Similarly, a module formed such that A/B becomes equal to 0.8 vol % / µm is designated as thermoelectric module PA22, a module formed such that A/B becomes equal to 1.5 vol % / µm is designated as thermoelectric module PA 23, a module formed such that A/B becomes equal to 2.3 vol %/µm is designated as thermoelectric module PA 24, a module formed such that A/B becomes equal to 2.5 vol % / µm is designated as thermoelectric module PA25, a module formed such that A/B becomes equal to 3.5 vol % / µm is designated as thermoelectric module PA26, and a module formed such that A/B becomes equal to 3.8 vol % / µm is designated as thermoelectric module PA 27.

Further, when maximum temperature difference (ΔT max) and maximum endothermic quantity (Qmax) are respectively determine in vacuum in a manner as described above by using the thermoelectric modules PA 21 to PA 27 which have been fabricated as described above, and ACR change rates (change rates of A.C. resistance) serving as index of reliability (stress relaxation) of the thermoelectric modules PA 21 to PA 27 are determined in a manner as described above, results as shown in the following Table 2 were obtained.

**Table 2**

| Modules | Resin Material | Filler | (C/4)-B (µm) | A/B (vol%/µm) | ΔTmax (°C) | Qmax (W) | ACR Change Rate |
|---|---|---|---|---|---|---|---|
| PA21 | Polyimide | Alumina | 45 | 0.5 | 71 | 205 | 1.1 |
| PA22 | Polyimide | Alumina | 45 | 0.8 | 70 | 204 | 1.1 |
| PA23 | Polyimide | Alumina | 45 | 1.5 | 71 | 203 | 1.4 |
| PA24 | Polyimide | Alumina | 45 | 2.3 | 72 | 205 | 1.2 |
| PA25 | Polyimide | Alumina | 45 | 2.5 | 71 | 208 | 1.3 |
| PA26 | Polyimide | Alumina | 45 | 3.5 | 69 | 209 | 1.8 |
| PA27 | Polyimide | Alumina | 45 | 3.8 | 67 | 215 | 7.5 |

As apparent from the results of the above-mentioned Table 2, it is understood that in the case where (C/4) - B is fixed to 45 µm, when A/B becomes equal to 3.8 (vol % / µm), the ACR change rate is abruptly elevated so that the reliability of the thermoelectric module PA 27 is lowered. From this fact, it is understood that in the case where there are used upper substrate 11 and lower substrate 12 in which resin material into which alumina powder is added as filler is formed of polyimide resin, when adjustment of quantity added of alumina powder as filler is made such that A/B becomes equal to 3.5 (vol % µm) or less, there can be obtained thermoelectric modules PA 21 to PA 26 of which reliability has been improved.

### 2 Example 2

A synthetic resin layer serving as thermoelectric module substrate of this example 2 is caused to be of thermoelectric module configuration similar to the above-described example 1 except that aluminum nitride powders (average grain diameter is 15 µm or less) are dispersed and added as filler, 200 pairs of thermoelectric elements 13 are used with dimensions of 2 mm (length) × 2 mm (width) × 2 mm (height), an element having composition represented by Bi_{0.4}Sb_{1.6}Te₃ is used as P-type semiconductor compound element, an element having composition represented by Bi_{1.9}Sb_{0.1}Te_{2.7}Se_{0.3} is used as N-type semiconductor element, and shearing extrusion molded body is used.

Here, in the case where contents volume percentage of fillers existing within synthetic resin layers of upper substrate 11 and lower substrate 12 is expressed as A (vol %), each thickness of the synthetic resin layers of upper substrate 11 and lower substrate 12 is expressed as B (µm), and total thickness of metallic layers at least including wiring pattern (copper film) 11 a and connecting copper film 11b (wiring pattern (copper film) 12a and connecting copper film 12b) is expressed as C µm (C = c1 + c2 = c3 + c4), each thickness of the synthetic resin layers of the upper substrate 11 and lower substrate 12 is fixed to 7 µm (B = 7 µm), and ratio A/B (vol %/µm) of contents volume percentage of fillers with respect to thicknesses of synthetic resin layers of these substrates is fixed to 2.0 (vol %/µm).

In this case, a module formed such that total thickness C (µm) of metallic layer is changed so that (C/4) - B becomes equal to 8 µm is designated as thermoelectric module PN11. Similarly, a module formed such that (C/4) - B becomes equal to 10 µm is designated as thermoelectric module PN12, a module formed such that (C/4) - B becomes equal to 19µm is designated as thermoelectric module PN13, a module formed such that (C/4) - B becomes equal to 38 µm is designated as thermoelectric module PN14, a module formed such that (C/4) - B becomes equal to 55 µm is designated as thermoelectric module PN15, a module formed such that (C/4) - B becomes equal to 65 µm is designated as thermoelectric module PN16, and a module formed such that (C/4) - B becomes equal to 70 µm is designated as thermoelectric module PN17.

When maximum temperature difference (ΔTmax) and maximum endothermic quantity (Qmax) are respectively determined in vacuum in a manner similar to the above by using the thermoelectric modules PN11 to PN17 which have been fabricated in a manner as described above, and ACR change rates (change rates ofA.C. resistance) serving as index of reliability (stress relaxation) of thermoelectric modules PN11 to PN17 are determined in a manner similar to the above, results as shown in the following Table 3 were obtained.

**Table 3**

| Modules | Resin Material | Filler | (C/4)-B (µm) | A/B (vol%/µm) | ΔTmax (°C) | Qmax (W) | ACR Change Rate |
|---|---|---|---|---|---|---|---|
| PN11 | Polyimide | Aluminum nitride | 8 | 2.0 | 72 | 205 | 1.2 |
| PN12 | Polyimide | Aluminum nitride | 1.0 | 2.0 | 70 | 205 | 1.2 |
| PN13 | Polyimide | Aluminum nitride | 19 | 2.0 | 71 | 204 | 1.1 |
| PN14 | Polyimide | Aluminum nitride | 38 | 2.0 | 70 | 205 | 1. 2 |
| PN15 | Polyimide | Aluminum nitride | 55 | 2.0 | 69 | 207 | 1.5 |
| PN16 | Polyimide | Aluminum nitride | 65 | 2. 0 | 70 | 206 | 1.4 |
| PN17 | Polyimide | Aluminum nitride | 70 | 2.0 | 68 | 206 | 6.8 |

As apparent from the results of the above Table 3, it is understood that remarkable difference cannot be observed at thermoelectric modules PN11 to P17 with respect to maximum temperature difference (ΔTmax) and maximum endothermic quantity (Qmax). On the other hand, when (C/4) - B, i.e., difference between thickness of 1/4 of total thickness of copper layer and thickness of resin layer becomes equal to 70µm, ACR change rate is abruptly elevated so that the reliability of the thermoelectric module PN 17 is lowered. From this fact, it is understood that in the case where there are used upper substrate 11 and lower substrate 12 in which resin material into which aluminum nitride powder is added as filler is formed of polyimide resin, when wiring pattern (copper film) 11a, connecting copper film 11b, wiring pattern (copper film) 12a and connecting copper film 12b are formed so that (C/4) - B becomes equal to 65 µm or less, there can be obtained thermoelectric modules PN11 to PN16 of which reliability has been improved.

Next, there was fabricated a thermoelectric module in which each thickness of synthetic resin layers of upper substrate 11 and lower substrate 12 is fixed to 15 µm (B =15 µm), total thickness C (µm) of metallic layer is fixed to 240 (µm), and (C/4) - B is fixed to 45 µm. In this case, a module formed such that ratio A/B (vol % / µm) of contents volume percentage of fillers with respect to the thickness of synthetic resin layers of these substrates is changed so that A/B becomes equal to 0.5 vol%/ µm is designated as thermoelectric module PN21. Similarly, a module formed such that A/B becomes equal to 0.8 vol %/µm is designated as thermoelectric module PN22, a module formed such that A/B becomes equal to 1.5 vol %/µm is designated as thermoelectric module PN23, a module formed such that A/B becomes equal to 2.3 vol %/µm is designated as thermoelectric module PN24, a module formed such that A/B becomes equal to 2.5 vol %/µm is designated as thermoelectric module PN25, a module formed such that A/B becomes equal to 3.5 vol % /µm is designated as thermoelectric module PN26, and a module formed such that A/B becomes equal to 3.8 vol %/µm is designated as thermoelectric module PN27.

Further, when maximum temperature difference (ΔTmax) and maximum endothermic quantity (Qmax) are respectively determined in vacuum in a manner as described above by using thermoelectric modules PN21 to PN27 which have been fabricated as described above, and ACR change rates (change rates of A.C. resistance) serving as index of reliability (stress relaxation) of respective thermoelectric modules PN21 to P27 are determined in a manner similar to the above, results as shown in the following Table 4 were obtained.

**Table 4**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| PA21 | Polyimide | Aluminum nitride | 45 | 0.5 | 71 | 205 | 1.2 |
| PA22 | Polyimide | Aluminum nitride | 45 | 0.8 | 72 | 204 | 1.2 |
| PA23 | Polyimide | Aluminum nitride | 45 | 1.5 | 71 | 203 | 1.4 |
| PA24 | Polyimide | Aluminum nitride | 45 | 2.3 | 72 | 205 | 1.2 |
| PA25 | Polyimide | Aluminum nitride | 45 | 2.5 | 72 | 208 | 1.3 |
| PA26 | Polyimide | Aluminum nitride | 45 | 3.5 | 69 | 209 | 1.8 |
| PA27 | Polyimide | Aluminum nitride | 45 | 3.8 | 68 | 215 | 7.2 |

As apparent from the result of the above Table 4, it is understood that in the case where (C/4) - B is fixed to 45 µm, when A/B becomes equal to 3.8 (vol % / µm), ACR change rate is abruptly elevated so that the reliability of the thermoelectric module PN27 is lowered. From this fact, it is understood that in the case where there are used upper substrate 11 and lower substrate 12 in which resin material into which aluminum nitride powder is added as filler is formed of polyimide resin, when adjustment of quantity added of aluminum nitride powder as filler is made so that A/B becomes equal to 3.5(vol%/µm), thermoelectric modules PN21 to PN26 of which reliability has been improved can be obtained.

### 3 Example 3

A synthetic resin layer serving as thermoelectric module substrate of this example 3 is caused to be of the thermoelectric module configuration similar to the above-described example 1 except that epoxy resin is used as resin material, 200 pairs of thermoelectric elements 13 are used with dimensions of 2 mm (length) × 2 mm (width) × 2 mm (height), an element having composition represented by Bi_{0.4}Sb_{1.6}Te₃ is used as P-type semiconductor compound element, an element having composition represented by Bi_{1.9}Sb_{0.1}Te_{2.7}Se_{0.3} is used as N-type semiconductor compound element, and shearing extrusion molded body is used.

Here, in the case where contents volume percentage of fillers existing within synthetic resin layers of upper substrate 11 and lower substrate 12 is expressed as A (vol %), each thickness of synthetic resin layers of upper substrate 11 and lower substrate 12 is expressed as B (µm), total thickness of metallic layers at least including wiring pattern (copper film) 11a and connecting copper film 11b (wiring pattern (copper film 12a) and connecting copper film 12b) is expressed as C µm (C = c1 + c2 = c3 + c4), there was fabricated a thermoelectric module in which thickness of synthetic resin layers of upper substrate 11 and lower substrate 12 is fixed to 30µm (B = 30 µm), ratio A/B (vol % / µm) of contents volume percentage of fillers with respect to each thickness of synthetic resin layers of these substrates is fixed to 2.5 (vol % / µm).

In this case, a module formed such that the total thickness C (µm) of the metallic layer is changed so that (C/4) -B becomes equal to -15 µm is designated as thermoelectric module EA11. Similarly, a module formed such that (C/4) - B becomes equal to 0 µm is designated as thermoelectric module EA12, a module formed such that (C/4) - B becomes equal to 19 µm is designated as thermoelectric module EA13, a module formed such that (C/4) - B becomes equal to 38 µm is designated as thermoelectric module EA14, a module such that (C/4) - B becomes equal to 55 µm is designated as thermoelectric module EA15, a module formed such that (C/4) - B becomes equal to 65 µm is designated as thermoelectric module EA16, and a module formed such that (C/4) - B becomes equal to 70 µm is designated as thermoelectric module EA17.

Further, when maximum temperature difference (ΔTmax) and maximum endothermic quantity (Qmax) are respectively determined in vacuum in a manner as described above by using thermoelectric modules TEA11 to EA17 which have been fabricated in a manner as described above, and ACR change rates (change rates of A.C. resistance) serving as index of reliability (stress relaxation) of thermoelectric modules EA11 to EA17 are determined in a manner as described above, results as shown in the following Table 5 were obtained.

**Table 5**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| EA11 | Epoxy | Alumina | -15 | 2.5 | 71 | 202 | 1.3 |
| EA12 | Epoxy | Alumina | 0 | 2.5 | 70 | 205 | 1.3 |
| EA13 | Epoxy | Alumina | 19 | 2.5 | 71 | 206 | 1.2 |
| EA14 | Epoxy | Alumina | 38 | 2.5 | 70 | 205 | 1.4 |
| EA15 | Epoxy | Alumina | 55 | 2.5 | 70 | 206 | 1.5 |
| EA16 | Epoxy | Alumina | 65 | 2.5 | 71 | 203 | 1.8 |
| EA17 | Epoxy | Alumina | 70 | 2.5 | 70 | 206 | 6.4 |

As apparent from the results of the above Table 5, it is understood that remarkable difference cannot be observed in thermoelectric modules PA11 to PA17 with respect to maximum temperature difference (ΔTmax) and maximum endothermic quantity (Qmax). On the other hand, it is understood that when (C/4) - B, i.e., difference between thickness of 1/4 of total thickness of copper layer and thickness of resin layer becomes equal to 70 µm, ACR change rate is abruptly elevated so that the reliability of the thermoelectric module EA17 is lowered.

From this fact, it is understood that in the case where there are used upper substrate 11 and lower substrate 12 in which resin material into which alumina powder is added as filler is formed of epoxy resin, when wiring pattern (copper film) 11a, connecting copper film 11b, wiring pattern (copper film) 12a, and connecting copper film 12b are formed so that (C/4) - B becomes equal to 65 µm or less, there can be obtained thermoelectric modules EA11 to EA16 of which reliability has been improved.

Next, there was fabricated a thermoelectric module in which each thickness of synthetic resin layers of the upper substrate 11 and the lower substrate 12 is fixed to 20 µm (B = 20 µm), total thickness C (µm) of metallic layer is fixed to 280 (µm), and (C/4) - B is fixed to 50 µm. In this case, a module formed such that ratio A/B (vol % /µm) of contents volume percentage of fillers with respect to thicknesses of synthetic resin layers of these substrates is changed so that A/B becomes equal to 0.5 vol %/µm is designated as thermoelectric module EA21. Similarly, a module formed such that A/B becomes equal to 0.8 vol % / µm is designated as thermoelectric module E22, a module formed such that A/B becomes equal to 1.5 vol % / µm is designated as thermoelectric module EA23, a module formed such that A/B becomes equal to 2.3 vol % / µm is designated as thermoelectric module EA24, a module formed such that A/B becomes equal to 2.5 vol % / µm is designated as thermoelectric module EA25, a module formed such that A/B becomes equal to 3.5 vol % / µm is designated as thermoelectric module EA26, and a module formed such that A/B becomes equal to 3.8 vol % / µm is designated as thermoelectric module EA27.

Further, when maximum temperature difference (ΔTmax) and maximum endothermic quantity (Qmax) are respectively determined in vacuum in a manner as described above by using thermoelectric modules EA21 to EA27 which have been fabricated in a manner as described above, and ACR change rates (change rates of A.C. resistance) serving as index of reliability (stress relaxation) of respective thermoelectric modules EA21 to EA27 are determined in a manner as described above, results as shown in the following Table 6 were obtained.

**Table 6**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| EA21 | Epoxy | Alumina | 50 | 0.5 | 71 | 205 | 1.1 |
| EA22 | Epoxy | Alumina | 50 | 0.8 | 72 | 204 | 1.1 |
| EA23 | Epoxy | Alumina | 50 | 1.5 | 71 | 206 | 1.4 |
| EA24 | Epoxy | Alumina | 50 | 2.3 | 72 | 205 | 1.2 |
| EA25 | Epoxy | Alumina | 50 | 2.5 | 71 | 208 | 1.3 |
| EA26 | Epoxy | Alumina | 50 | 3.5 | 70 | 209 | 1.8 |
| EA27 | Epoxy | Alumina | 50 | 3.7 | 67 | 215 | 7. 7 |

As apparent from the results of the above Table 6, it is understood that in the case where (C/4) - B is fixed to 50 µm, when A/B becomes equal to 3.7 (vol % / µm), ACR change rate is abruptly elevated so that the reliability of the thermoelectric module EA27 is lowered. From this fact, it is understood that in the case where there are used upper substrate I 1 and lower substrate 12 in which resin material into which alumina powder is added as filler is formed of epoxy resin, when adjustment of quantity added of alumina powder as filler is made so that A/B becomes equal to 3.5(vol%/µm), there can be obtained thermoelectric modules EA21 to EA26 of which reliability has been improved.

### 4 Example 4

A synthetic resin layer serving as thermoelectric module substrate of this example 4 is caused to be of the thermoelectric module configuration similar to the above-described example 1 except that epoxy resin is used as resin material, aluminum nitride powders (average grain diameter is 15 µm or less) are dispersed and added as filler, 200 pairs of thermoelectric elements 13 are used with dimensions of 2 mm (length) × 2 mm (width) × 2 mm (height), an element having composition represented by Bi_{0.4}Sb_{1.6}Te₃ is used as P-type semiconductor compound element, an element having composition represented by Bi_{1.9}Sb_{0.1}Te_{2.7}Se_{0.3} is used as N-type semiconductor compound element, and shearing extrusion molded body is used.

Here, in the case where contents volume percentage of fillers existing within synthetic resin layers of the upper substrate 11 and the lower substrate 12 is expressed as A (vol %), each thicknesses of synthetic resin layers of upper substrate 11 and lower substrate 12 is expressed as B (µm), and total thickness of metallic layers at least including wiring pattern (copper film) 11a and connecting copper film 11b (wiring pattern (copper film) 12a and connecting copper film 12b) is expressed as C µm (C = c1 + c2 = c3 + c4), there was fabricated a thermoelectric module in which each thickness of synthetic resin layers of upper substrate 11 and lower substrate 12 is fixed to 30 µm (B = 30 µm), and ratio A/B (vol % / µm) of contents volume percentage of fillers with respect to each thickness of synthetic resin layers of these substrates is fixed to 2.5 (vol % / µm).

In this case, a module formed such that total thickness C(µm) of the metallic layer is changed so that (C/4) - B becomes equal to -20 µm is designated as thermoelectric module EN11. Similarly, a module formed such that (C/4) - B becomes equal to 0 µm is designated as thermoelectric module EN12, a module formed such that (C/4) - B becomes equal to 19 µm is designated as thermoelectric module EN13, a module formed such that (C/4) - B becomes equal to 38 µm is designated as thermoelectric module EN14, a module formed such that (C/4) - B becomes equal to 55 µm is designated as EN15, a module formed such that (C/4) - B becomes equal to 65 µm is designated as thermoelectric module EN16, and a module formed such that (C/4) - B becomes equal to 70 µm is designated as thermoelectric module EN17.

Further, when maximum temperature difference (ΔTmax) and maximum endothermic quantity (Qmax) are respectively determined in vacuum in a manner as described above by using the thermoelectric modules EN11 to EN17 which have been fabricated as described above, and ACR change rates (change rates of A.C. resistance) serving as index of reliability (stress relaxation) of the thermoelectric modules EN11 to EN17 are determined in a manner as described above, results as shown in the following Table 7 were obtained.

**Table 7**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| EN11 | Epoxy | Aluminum nitride | -20 | 2.5 | 72 | 205 | 1.1 |
| EN12 | Epoxy | Aluminum nitride | 0 | 2. 5 | 71 | 207 | 1.2 |
| EN13 | Epoxy | Aluminum nitride | 19 | 2.5 | 72 | 209 | 1.2 |
| EN14 | Epoxy | Aluminum nitride | 38 | 2.5 | 71 | 209 | 1. 2 |
| EN15 | Epoxy | Aluminum nitride | 55 | 2.5 | 71 | 210 | 1.5 |
| EN16 | Epoxy | Aluminum nitride | 65 | 2.5 | 71 | 211 | 1. 7 |
| EN17 | Epoxy | Aluminum nitride | 70 | 2.5 | 71 | 209 | 7.2 |

As apparent from the results of the above Table 7, it is understood that remarkable difference cannot be observed at the thermoelectric modules PA11 to PA17 with respect to maximum temperature difference (ΔTmax) and maximum endothermic quantity (Qmax). On the other hand, it is understood that when (C/4) - B, i.e., difference between thickness of 1/4 of total thickness of copper layer and thickness of resin layer becomes equal to 70 µm, ACR change rate is abruptly elevated so that the reliability of the thermoelectric module EN17 is lowered. From this fact, it is understood that in the case where there are used upper substrate 11 and lower substrate 12 in which resin material into which aluminum nitride powder is added as filler is formed of epoxy resin, when wiring pattern (copper film) 11 a, connecting copper film 11b, wiring pattern (copper film) 12a and connecting copper film 12b are formed so that (C/4) - B becomes equal to 65 µm or less, there can be obtained thermoelectric modules EN11 to EN16 of which reliability has been improved.

Next, there was fabricated a thermoelectric module in which each thickness of synthetic resin layers of the upper substrate 11 and the lower substrate 12 is fixed to 20 µm (B = 20 µm), total thickness C (µm) of the metallic layer is fixed to 280 (µm) and (C/4) - B is fixed to 50 µm. In this case, a module formed such that ratio A/B (vol %/µm) of contents volume percentage of fillers with respect to each thickness of synthetic resin layers of these substrates is changed so that A/B becomes equal to 0.5 vol % / µm is designated as thermoelectric module EN21. Similarly, a module formed such that A/B becomes equal to 0.8 is designated as thermoelectric module EN22, a module formed such that A/B becomes equal to 1.5 vol % / µm is designated as thermoelectric module EN23, a module formed such that A/B becomes equal to 2.3 vol % / µm is designated as thermoelectric module EN24, a module formed such that A/B becomes equal to 2.5 vol%/µm is designated as thermoelectric module EN25, a module formed such that A/B becomes equal to 3.5 vol % / µm is designated as thermoelectric module EN26, and a module formed such that A/B becomes equal to 3.7 vol % / µm is designated as thermoelectric module EN27.

Further, when maximum temperature difference (ΔTmax) and maximum endothermic quantity (Qmax) are respectively determined in vacuum in a manner as described above by using thermoelectric modules EN21 to EN27 which have been fabricated in a manner as described above, and ACR change rates (change rates ofA.C. resistance) serving as index of reliability (stress relaxation) of thermoelectric modules EN21 to EN27 are determined in a manner as described above, results as shown in the following Table 8 were obtained.

**Table 8**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| EN21 | Epoxy | Aluminum nitride | 50 | 0.5 | 71 | 205 | 1.1 |
| EN22 | Epoxy | Aluminum nitride | 50 | 0.8 | 71 | 208 | 1.1 |
| EN23 | Epoxy | Aluminum nitride | 50 | 1.5 | 71 | 208 | 1.1 |
| EN24 | Epoxy | Aluminum nitride | 50 | 2.3 | 72 | 206 | 1.2 |
| EN25 | Epoxy | Aluminum nitride | 50 | 2.5 | 71 | 208 | 1.4 |
| EN26 | Epoxy | Aluminum nitride | 50 | 3.5 | 70 | 208 | 1.7 |
| EN27 | Epoxy | Aluminum nitride | 50 | 3.7 | 69 | 209 | 7.6 |

As apparent from the results of the above Table 8, it is understood that in the case where (C/4) - B is fixed to 50 µm, when A/B becomes equal to 3.7 (vol % / µm), the ACR change rate is abruptly elevated so that the realibility of the thermoelectric module EN27 is lowered. From this fact, it is understood that in the case where there are used upper substrate 11 and lower substrate 12 in which resin material into which aluminum nitride powder is added as filler is formed of epoxy resin, when adjustment of quantity added of aluminum nitride powder as filler is made so that A/B becomes equal to 3.5 (vol % / µm) on less, thermoelectric modules EN21 to EN26 of which reliability has been improved can be obtained.

### 5 Example 5

A synthetic resin layer serving as thermoelectric module substrate of this example 5 is caused to be of the thermoelectric module configuration similar to the above-described example 1 except that magnesium oxide powders (average grain diameter is 15 µm or less) are dispersed and added as filler, 128 pairs of thermoelectric elements 13 are used with dimensions of 2 mm (length) × 2 mm (width) × 1.5 mm (height), an element having composition represented by Bi_{0.5}Sb_{1.5}Te₃ is used as P-type semiconductor compound element and an element having composition represented by Bi_{1.9}Sb_{0.1}Te_{2.75}Se_{0.25} is used as N-type semiconductor compound element, and hot press sintered molded body is used.

Here, in the case where contents volume percentage of fillers existing within synthetic resin layers of upper substrate 11 and lower substrate 12 is expressed as A (vol %), each thickness of synthetic resin layers of the upper substrate 11 and the lower substrate 12 is expressed as B(µm), and total thickness of metallic layers including wiring pattern (copper film) 11 a and connecting copper film 11b (wiring pattern (copper film) 12a and connecting copper film 12b) is expressed as Cµm (C = c1 + c2 = c3 + c4), there was fabricated a thermoelectric module in which each thickness of synthetic resin layers of upper substrate 11 and lower substrate 12 is fixed to 17 µm (B = 17 µm), and ratio A/B (vol % / µm) of contents volume percentage of fillers with respect to the thickness of synthetic resin layers of these substrates is fixed to 2.0 (vol % / µm).

In this case, a module formed such that total thickness C (µm) of the metallic layer is changed so that (C/4) - B becomes equal to 0 µm is designated as thermoelectric module PM11, Similarly, a module formed such that (C/4) - B becomes equal to 5 µm is designated as thermoelectric module PM12, a module formed such that (C/4) - B becomes equal to 16 µm is designated as thermoelectric module PM13, a module formed such that (C/4) - B becomes equal to 40µm is designated as thermoelectric module PM14, a module formed such that (C/4) - B becomes equal to 56 µm is designated as thermoelectric module PM15, a module formed such that (C/4) - B becomes equal to 65 µm is designated as thermoelectric module PM16, and a module formed such that (C/4) - B becomes equal to 70 µm is designated as thermoelectric module PM17.

Further, when maximum temperature difference (ΔTmax) and maximum endothermic quantity (Qmax) are respectively determined in vacuum in a manner as described above by using the thermoelectric modules PM11 to PM17 which have been fabricated as described above, and ACR change rates (change rates of A.C. resistance) serving as index of reliability (stress relaxation) of thermoelectric modules PM11 to PM17 are determined in a manner described above, results as shown in the following Table 9 were obtained.

**Table 9**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| PM11 | Polyimide | Magnesium oxide | 0 | 2.0 | 69 | 203 | 1.1 |
| PM12 | Polyimide | Magnesium oxide | 5 | 2. 0 | 70 | 203 | 1. |
| PM13 | Polyimide | Magnesium oxide | 16 | 2.0 | 70 | 204 | 1.2 |
| PM14 | Polyimide | Magnesium oxide | 40 | 2.0 | 70 | 205 | 1.1 |
| PM15 | Polyimide | Magnesium oxide | 56 | 2.0 | 69 | 202 | 1.5 |
| PM16 | Polyimide | Magnesium oxide | 65 | 2.0 | 69 | 205 | 1.6 |
| PM17 | Polyimide | Magnesium oxide | 70 | 2.0 | 69 | 206 | 5.5 |

As apparent from the results of the above Table 9, it is understood that remarkable difference cannot be observed at thermoelectric modules PA11 to PA17 with respect to the maximum temperature difference (ΔT max) and the maximum endothermic quantity (Q max). On the other hand, when (C/4) - B, i.e., the difference between the thickness of 1/4 of total thickness of copper layer and the thickness of resin layer becomes equal to 70 µm, the ACR change rate is abruptly elevated so that the reliability of the thermoelectric module PM17 is lowered. From this fact, it is understood that in the case where there are used upper substrate 11 and lower substrate 12 in which resin material into which magnesium oxide powder is added as filler is formed of polyimide resin, when wiring pattern (copper film) 11a, connecting copper film 11b, wiring pattern (copper film) 12a, and connecting copper film 12b are formed so that (C/4) - B becomes equal to 65 µm or less, there can be obtained thermoelectric modules PM11 to PM16 of which reliability has been improved.

Next, there was fabricated a thermoelectric module in which each thickness of synthetic resin layers of the upper substrate 11 and the lower substrate 12 is fixed to 15 µm (B = 15 µm), total thickness C (µm) of the metallic layer is fixed to 240 (µm), and (C/4) - B is fixed to 45 µm. In this case, a module formed such that ratio A/B (vol % / µm) of contents volume percentage of fillers with respect to each thickness of synthetic resin layers of these substrates is changed so that A/B becomes equal to 0.5 vol % / µm is designated as thermoelectric module PM21. Similarly, a module formed such that A/B becomes equal to 0.8 vol % / µm is designated as thermoelectric module PM22, a module formed such that A/B becomes equal to 1.5 vol % / µm is designated as thermoelectric module PM 23, a module formed such that A/B becomes equal to 2.3 vol % / µm is designated as thermoelectric module PM24, a module formed such that A/B becomes equal to 2.5 vol % / µm is designated as thermoelectric module PM25, a module formed such that A/B becomes equal to 3.5 vol % / µm is designated as thermoelectric module PM26, and a module formed such that A/B becomes equal to 3.7 vol % / µm is designated as thermoelectric module PM27.

Further, when maximum temperature difference (ΔTmax) and maximum endothermic quantity (Qmax) are respectively determined in vacuum in a manner as described above by using the thermoelectric modules PM21 to PM27 which have been fabricated as described above, and ACR change rates (change rates ofA.C. resistance) serving as index of reliability (stress relaxation) of thermoelectric modules PM21 to PM27 are determined in a manner as described above, results as shown in the following Table 10 were obtained.

**Table 10**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| PM21 | Polyimide | Magnesium oxide | 45 | 0.5 | 71 | 205 | 1. 1 |
| PM22 | Polyimide | Magnesium oxide | 45 | 0.8 | 70 | 203 | 1. 1 |
| PM23 | Polyimide | Magnesium oxide | 45 | 1. 5 | 71 | 205 | 1.4 |
| PM24 | Polyimide | Magnesium oxide | 45 | 2.3 | 72 | 204 | 1.2 |
| PM25 | Polyimide | Magnesium oxide | 45 | 2.5 | 71 | 206 | 1.1 |
| PM26 | Polyimide | Magnesium oxide | 45 | 3.5 | 69 | 206 | 1.6 |
| PM27 | Polyimide | Magnesium oxide | 45 | 3.7 | 68 | 206 | 6.8 |

As apparent from the results of the above Table 1.0, it is understood that in the case where (C/4) - B is fixed to 45 µm, when A/B becomes equal to 3.7 (vol % / µm), the ACR change rate is abruptly elevated so that the reliability of the thermoelectric module PM27 is lowered. From this fact, it is understood that in the case where there are used upper substrate 11 and lower substrate 12 in which resin material into which magnesium oxide powder is added as filler is formed of polyimide resin, when adjustment of quantity added of magnesium oxide powder as filler is made so that A/B becomes equal to 3.5 (vol % / µm) or less, there can be obtained thermoelectric modules PM21 to PM26 of which reliability has been improved.

### 6 Example 6

A synthetic resin layer serving as thermoelectric module substrate of this example 6 is caused to be of the thermoelectric module configuration similar to the above-described example 1 except that epoxy resin is used as resin material, magnesium oxide powders (average grain diameter is 15µm or less) are dispersed and added as filler, 128 pairs of thermoelectric elements 13 are used with dimensions of 2mm (length) x2 mm (width) ×1.5 mm (height), an element having composition represented by Bi_{0.5}Sb_{1.5}Te₃ is used as P-type semiconductor compound element, an element having composition represented by Bi_{1.9}Sb_{0.1}Te_{2.75}Se_{0.25} is used as N-type semiconductor compound element, and hot press sintered body is used.

Here, in the case where contents volume percentage of fillers existing within synthetic resin layers of the upper substrate 11 and the lower substrate 12 is expressed as A (vol%), each thickness of synthetic resin layers of the upper substrate 11 and the lower substrate 12 is expressed as B (µm), and total thickness of metallic layers including wiring pattern (copper film) 11a and connecting copper film 11b (wiring pattern (copper film) 12a and connecting copper film 12b) is expressed as Cµm (C = c1 + c2 = c3 + c4), there was fabricated a thermoelectric module in which each thickness of synthetic resin layers of the upper substrate 11 and the lower substrate 12 is fixed to 17 µm (B= 17µm), and ratio A/B (vol %/µm) of contents volume percentage of fillers with respect to each thickness of synthetic resin layers of these substrates is fixed to 2.5 (vol%/µm).

In this case, a module formed such that total thickness C (µm) of the metallic layer is changed so that (C/4) - B becomes equal to 0 µm is designated as thermoelectric module EM11, Similarly, a module formed such that (C/4) - B becomes equal to 10µm is designated as thermoelectric module EM12, a module formed such that (C/4) - B becomes equal to 18µm is designated as thermoelectric module EM13, a module formed such that (C/4) - B becomes equal to 39µm is designated as thermoelectric module EM 14, a module formed such that (C/4) - B becomes equal to 58 µm is designated as thermoelectric module EM 15, a module formed such that (C/4) - B becomes equal to 65µm is designated as thermoelectric module EM 16, and a module formed such that (C/4) - B becomes equal to 70µm is designated as thermoelectric module EM 17.

Further, when maximum temperature difference (ΔTmax) and maximum endothermic quantity (Qmax) are respectively determined in vacuum in a manner as described above by using thermoelectric modules EM11 to EM 17 which have been fabricated as described above, and ACR change rates (change rates of A.C. resistance) serving as index of reliability (stress relaxation) of thermoelectric modules EM11 to EM 17 are determined in a manner described above, results as shown in the following Table 11 were obtained.

**Table 11**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| EM11 | Epoxy | Magnesium oxide | 0 | 2.5 | 71 | 206 | 1. 2 |
| EM12 | Epoxy | Magnesium oxide | 10 | 2.5 | 70 | 206 | 1.1 |
| EM13 | Epoxy | Magnesium oxide | 18 | 2.5 | 71 | 205 | 1.2 |
| EM14 | Epoxy | Magnesium oxide | 39 | 2.5 | 70 | 205 | 1.3 |
| EM15 | Epoxy | Magnesium oxide | 58 | 2.5 | 71 | 206 | 1.5 |
| EM16 | Epoxy | Magnesium oxide | 65 | 2.5 | 70 | 207 | 1.8 |
| EM17 | Epoxy | Magnesium oxide | 70 | 2.5 | 69 | 207 | 6.6 |

As apparent from the results of the above Table 11, it is understood that remarkable difference cannot be observed at thermoelectric modules PA11 to PA17 with respect to maximum temperature difference (ΔTmax) and maximum endothermic quantity (Qmax). On the other hand, it is understood that when (C/4) - B, i.e., difference between the thickness of 1/4 of total thickness of copper layer and thickness of resin layer becomes equal to 70µm, the ACR change rate is abruptly elevated so that the reliability of the thermoelectric module EM 17 is lowered. From this fact, it is understood that in the case where there are used upper substrate 11 and lower substrate 12 in which resin material into which magnesium oxide powder is added as filler, when wiring pattern (copper film) 11a, connecting copper film 11b, wiring pattern (copper film) 12a and connecting copper film 12b are formed so that (C/4) - B becomes equal to 65 µm or less, there can be obtained thermoelectric modules EM 11 to EM 16 of which reliability has been improved.

Next, there was fabricated a thermoelectric module in which each thickness of synthetic resin layers of upper substrate 11 and lower substrate 12 is fixed to 20 µm (B = 20 µm), total thickness C (µm) of metallic layer is fixed to 280 (µm), and (C/4) - B is fixed to 50 µm. In this case, a module formed such that ratio A/B (vol % / µm) of contents volume percentage of fillers with respect to the thickness of the synthetic resin layer of these substrates is changed so that A/B becomes equal to 0.5 vol % / µm is designated as thermoelectric module EM21. Similarly, a module formed such that A/B becomes equal to 0.8 vol % / µm is designated as thermoelectric module EM22, a module formed such that A/B becomes equal to 1.5 vol % / µm is designated as thermoelectric module EM23, a module formed such that A/B becomes equal to 2.3 vol % / µm is designated as thermoelectric module EM24, a module formed such that A/B becomes equal to 2.5 vol % / µm is designated as thermoelectric module EM25, a module formed such that A/B becomes equal to 3.5 vol % / µm is designated as thermoelectric module EM26, and a module formed so that A/B becomes equal to 3.7 vol % / µm is designated as thermoelectric module EM27.

Further, when maximum temperature difference (ΔTmax) and maximum endothermic quantity (Qmax) are respectively determined in vacuum in a manner described above by using the thermoelectric modules EM21 to EM27 which have been fabricated in a manner as described above, and ACR change rates (change rates of A.C. resistance) serving as index of reliability (stress relaxation) of thermoelectric modules EM21 to EM27 are determined in a manner described above, results as shown in the following Table 12 were obtained.

**Table 12**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| EM21 | Epoxy | Magnesium oxide | 50 | 0.5 | 71 | 207 | 1.1 |
| EM22 | Epoxy | Magnesium oxide | 50 | 0.8 | 70 | 206 | 1.1 |
| EM23 | Epoxy | Magnesium oxide | 50 | 1.5 | 71 | 206 | 1.2 |
| EM24 | Epoxy | Magnesium oxide | 50 | 2.3 | 72 | 209 | 1.1 |
| EM25 | Epoxy | Magnesium oxide | 50 | 2.5 | 71 | 207 | 1.4 |
| EM26 | Epoxy | Magnesium oxide | 50 | 3.5 | 69 | 209 | 1.7 |
| EM27 | Epoxy | Magnesium oxide | 50 | 3.7 | 67 | 207 | 7.3 |

As apparent from the results of the above Table 12, it is understood that in the case where (C/4) - B is fixed to 50 µm, when A/B becomes equal to 3.7 (vol % / µm), the ACR change rate is abruptly elevated so that the reliability of the thermoelectric module EM27 is lowered. From this fact, it is understood that in the case where there are used upper substrate 11 and lower substrate 12 in which resin material into which magnesium oxide powder is added as filler is formed of epoxy resin, when adjustment of quantity added of magnesium oxide powder as filler is made so that A/B becomes equal to 3.5 (vol % / µm) or less, there can be obtained thermoelectric modules EM21 to EM26 of which reliability has been improved.

### 7 Example 7

A synthetic resin layer serving as thermoelectric module substrate of this example 7 is caused to be of the thermoelectric module configuration similar to the above-described example 1 except that graphite powders (average grain diameter is 1 µm or less) are dispersed and added as filler (In this case, graphite powders are added so that those graphite materials are not included within the range of 7% of total thickness of the synthetic resin layer from the surface of the synthetic resin layer), 242 pairs of thermoelectric element 13 are used with dimensions of 2 mm (length) × 2 mm (width) × 2 mm (height) are used, an element having composition represented by Bi_{0.5}Sb_{1.5}Te₃ is used as P-type semiconductor compound element, an element having composition represented by Bh_{1.9}Sb_{0.1}Te_{2.8}Se_{0.2} is used as N-type semiconductor compound element, and ingot molded body is used.

Here, in the case where contents volume percentage of fillers existing within synthetic resin layers of upper substrate 11 and lower substrate 12 is expressed as A (vol %), each thickness of synthetic resin layers of upper substrate 11 and lower substrate 12 is expressed as B (µm), and total thickness of metallic layers including wiring pattern (copper film) 11a and connecting copper film 11b (wiring pattern (copper film) 12a and connecting copper film 12b) is expressed as C µm (C = c1 + c2 = c3 + c4), there was fabricated a thermoelectric module in which each thickness of synthetic resin layers of upper substrate 11 and lower substrate 12 is fixed to 30 µm (B = 30 µm), and ratio A/B (vol % / µm) of contents volume percentage of fillers with respect to the thickness of synthetic resin layers of these substrates is fixed to 2.5 (vol % /µm).

In this case, a module formed such that total thickness C (µm) of the metallic layer is changed so that (C/4) - B becomes equal to -10 µm is designated as thermoelectric module PG11. Similarly, a module formed such that (C/4) - B becomes equal to 0 µm is designated as thermoelectric module PG12, a module formed such that (C/4) - B becomes equal to 16 µm is designated as thermoelectric module PG13, a module formed such that (C/4) - B becomes equal to 40 µm is designated as thermoelectric module PG14, a module formed such that (C/4) - B becomes equal to 56 µm is designated as thermoelectric module PG15, a module formed such that (C/4) - B becomes equal to 65 µm is designated as thermoelectric module PG16, and a module formed such that (C/4) - B becomes equal to 70 µm is designated as thermoelectric module PG17.

Further, when maximum temperature difference (ΔTmax) and maximum endothermic quantity (Qmax) are respectively determined in vacuum in a manner as described above by using thermoelectric modules PG11 to PG17 which have been fabricated in a manner described above, and ACR change rates (change rates ofA.C. resistance) serving as index of reliability (stress relaxation) of thermoelectric modules PG11 to PG17 are determined in a manner described above, results as shown in the following Table 13 were obtained.

**Table 13**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| PG11 | Polyimide | Graphite | -10 | 2.5 | 69 | 205 | 1.2 |
| PG12 | Polyimide | Graphite | 0 | 2. 5 | 70 | 205 | 1.1 |
| PG13 | Polyimide | Graphite | 16 | 2.5 | 70 | 204 | 1. 2 |
| PG14 | Polyimide | Graphite | 40 | 2.5 | 70 | 205 | 1.1 |
| PG15 | Polyimide | Graphite | 56 | 2.5 | 69 | 202 | 1.7 |
| PG16 | Polyimide | Graphite | 65 | 2.5 | 69 | 206 | 1.6 |
| PG17 | Polyimide | Graphite | 70 | 2.5 | 69 | 206 | 5.5 |

As apparent from the results of the above Table 13, it is understood that remarkable difference cannot be observed at thermoelectric modules PA11 to PA17 with respect to maximum temperature difference (ΔTmax) and maximum endothermic quantity (Qmax). On the other hand, it is understood that when (C/4) - B, i.e., the difference between the thickness of 1/4 of total thickness of copper layer and thickness of resin layer becomes equal to 70 µm, the ACR change rate is abruptly elevated so that the reliability of the thermoelectric module PG17 is lowered. From this fact, it is understood that in the case where there are used upper substrate 11 and lower substrate 12 in which resin material into which graphite powder is added as filler is formed of polyimide resin, when wiring pattern (copper film) 11a, connecting copper film 11b, wring pattern (copper film) 12a, and connecting copper film 12b are formed so that (C/4) - B becomes equal to 65 µm or less, there can be obtained thermoelectric modules PG11 to PG16 of which reliability has been improved. In this case, in order to maintain insulating property at synthetic resin layer, it is necessary to add graphite so that the graphite is not included within the range of at least 5% of total thickness of synthetic resin layer from the surface of the synthetic resin layer.

Next, there was fabricated a thermoelectric module in which each thickness of synthetic resin layers of upper substrate 11 and lowers substrate 12 is fixed to 25 µm (B = 25 µm), total thickness C (µm) of metallic layer is fixed to 160 (µm), and (C/4) - B is fixed to 15 µm. In this case, a module formed such that ratio A/B (vol % / µm) of contents volume percentage of fillers with respect to the thickness of synthetic resin layers of these substrates is changed so that A/B becomes equal to 0.5 vol % / µm is designated as thermoelectric module PG21. Similarly, a module formed such that A/B becomes equal to 0.8 vol % / µm is designated as thermoelectric module PG22, a module formed such that A/B becomes equal to 1.5 vol % / µm is designated as thermoelectric module 23, a module formed such that A/B becomes equal to 2.3 vol % / µm is designated as thermoelectric module PG24, a module formed such that A/B becomes equal to 2.5 vol % / µm is designated as thermoelectric module PG25 a module formed such that A/B becomes equal to 3.5 vol % / µm is designated as thermoelectric module PG26, and a module formed such that A/B becomes equal to 3.7 vol % / µm is designated as thermoelectric module PG27.

Further, when maximum temperature difference (ΔTmax) and maximum endothermic quantity (Qmax) are respectively determined in vacuum in a manner as described above by using thermoelectric modules PG21 to PG27 which have been fabricated in a manner as described above, and ACR change rates (change rates of A.C. resistance) serving as index of reliability (stress relaxation) of thermoelectric modules PG21 to PG27 are determined in a manner as described above, results as shown in the following Table 14 were obtained.

**Table 14**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| PG21 | Polyimide | Graphite | 15 | 0. 5 | 71 | 205 | 1.1 |
| PG22 | Polyimide | Graphite | 15 | 0.8 | 70 | 204 | 1.1 |
| PG23 | Polyimide | Graphite | 15 | 1.5 | 71 | 206 | 1.4 |
| PG24 | Polyimide | Graphite | 15 | 2.3 | 72 | 205 | 1.2 |
| PG25 | Polyimide | Graphite | 15 | 2.5 | 71 | 208 | 1. 3 |
| PG26 | Polyimide | Graphite | 15 | 3.5 | 69 | 209 | 1.8 |
| PG27 | Polyimide | Graphite | 15 | 3. 7 | 67 | 209 | 6.8 |

As apparent from the results of the Table 14, it is understood that in the case where (C/4) - B is fixed to 15 µm, when A/B becomes equal to 3.7 (vol % / µm), the ACR change rate is abruptly elevated so that the reliability of the thermoelectric module PG27 is lowered. From this fact, it is understood that in the case where there are used upper substrate 11 and lower substrate 12 in which resin material into which graphite powder is added as filler is formed of polyimide resin, when adjustment of quantity added of graphite powder as filler is made so that A/B becomes equal to 3.5 (vol%/µm) or less, there can be obtained thermoelectric modules PG21 to PG26 of which reliability has been improved. In this case, in order to maintain insulating property at the synthetic resin layer, it is required to add graphite so that the graphite is not included within the range of at least 5% of total thickness of synthetic resin layer from the surface of the synthetic resin layer.

### 8 Example 8

A synthetic resin layer serving as the thermoelectric module substrate of this example 8 is caused to be of the thermoelectric module configuration similar to the above-described example 1 except that epoxy resin is used as resin material, carbon nanotubes (CNT: average grain diameter is 1 µm or less) are dispersed and added as filler (In this case, CNT is added so that the CNT is not included within the range of 8% of total thickness of synthetic resin layer from the surface of the synthetic resin layer), 242 pairs of thermoelectric elements 13 are used with dimensions of 2 mm (length) × 2 mm (width) × 2 mm (height), an element having composition represented by Bi_{0.5}Sb_{1.5}Te₃ is used as P-type semiconductor compound element, an element having composition represented by Bi_{1.9}Sb_{0.1}Tc_{2.8}Se_{0.2} is used as N-type semiconductor compound element, and ingot molded body is used.

Here, in the case where contents volume percentage of fillers existing within synthetic resin layers of upper substrate 11 and lower substrate 12 is expressed as A (vol %), thickness of synthetic resin layers of upper substrate 11 and lower substrate 12 is expressed as B (µm), and total thickness of metallic layers including wiring pattern (copper film) 11 a and connecting copper film 11b (wiring pattern (copper film) 12a and connecting copper film 12b) is expressed as Cµm (C = c1 + c2 = c3 + c4), there was fabricated a thermoelectric module in which each thickness of synthetic resin layers of upper substrate 11 and lower substrate 12 is fixed to 10 µm (B = 10 µm), and ratio A/B (vol % / µm) having contents volume percentage of fillers with respect to each thickness of synthetic resin layers of these substrates is fixed to 2.0 (vol % / µm).

In this case, a module formed such that total thickness C (µm) of metallic layer is changed so that (C/4) - B becomes equal to 0 µm is designated as thermoelectric module PC11. Similarly, a module formed such that (C/4) - B becomes equal to 8 µm is designated as thermoelectric module PC 12, a module formed such that (C/4) - B becomes equal to 18 µm is designated as thermoelectric module PC 13, a module formed such that (C/4) - B becomes equal to 39 µm is designated as thermoelectric module PC14, a module formed such that (C/4) - B becomes equal to 58 µm is designated as thermoelectric module PC15, a module formed such that (C/4) - B becomes equal to 65 µm is designated as thermoelectric module PC16, and a module formed such that (C/4) - B becomes equal to 70 µm is designated as thermoelectric module PC17.

Further, when maximum temperature difference (ΔTmax) and maximum endothermic quantity (Qmax) are respectively determined in vacuum in a manner as described above by using thermoelectric modules PC11 to PC17 which have been fabricated in a manner as described above, and ACR change rates (change rates of A.C. resistance) serving as index of reliability (stress relaxation) of thermoelectric modules PC11 to PC17 are determined in a manner as described above, results as shown in the following Table 15 were obtained.

**Table 15**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| PC11 | Epoxy | CNT | 0 | 2.0 | 69 | 211 | 1.2 |
| PC12 | Epoxy | CNT | 8 | 2.0 | 70 | 212 | 1.1 |
| PC13 | Epoxy | CNT | 18 | 2.0 | 71 | 210 | 1. 1 |
| PC14 | Epoxy | CNT | 39 | 2.0 | 70 | 209 | 1.4 |
| PC15 | Epoxy | CNT | 58 | 2. 0 | 71 | 209 | 1.7 |
| PC16 | Epoxy | CNT | 65 | 2.0 | 70 | 212 | 2.1 |
| PC17 | Epoxy | CNT | 70 | 2.0 | 69 | 210 | 6.7 |

As apparent from the results of the above Table 15, it is understood that remarkable difference cannot be observed at thermoelectric modules PA11 to PA17 with respect to maximum temperature difference (ΔTmax) and maximum endothermic quantity (Qmax). On the other hand, it is understood that when (C/4) - B, i.e., the difference between the thickness of 1/4 of total thickness of copper layer and the thickness of the resin layer becomes equal to 70 µm, the ACR change rate is abruptly elevated so that the reliability of the thermoelectric module PC17 is lowered. From this fact, it is understood that in the case where there are used upper substrate 11 and lower substrate 12 in which resin material into which CNT is added as filler is formed of epoxy resin, when wiring pattern (copper film) 11a, connecting copper film 11b, wiring pattern (copper film) 12a, and connecting copper film 12b are formed so that (C/4) - B becomes equal to 65 µm or less, there can be obtained thermoelectric modules PC11 to PC16 of which reliability has been improved. In this case, in order to maintain insulating property at synthetic resin layer, it is required to add CNT so that the CNT is not included within the range of at least 5% of total thickness of the synthetic resin layer from the surface of the synthetic resin layer.

Next, there was fabricated a thermoelectric module in which each thickness of synthetic resin layers of the upper substrate 11 and the lower substrate 12 is fixed to 15 µm (B = 15 µm), total thickness C (µm) of metallic layer is fixed to 240 (µm) and (C/4) - B is fixed to 45 µm. In this case, a module formed such that ratio A/B (vol % / µm) of contents volume percentage of fillers with respect to each thickness of synthetic resin layers of these substrates is changed so that A/B becomes equal to 0.5 vol % / µm is designated as thermoelectric module PC21. Similarly, a module formed such that A/B becomes equal to 0.8 vol % / µm is designated as thermoelectric module PC22, a module formed such that A/B becomes equal to 1.5 vol % / µm is designated as thermoelectric module PC23, a module formed such that A/B becomes equal to 2.3 vol % / µm is designated as thermoelectric module PC24, a module formed such that A/B becomes equal to 2.5 vol % / µm is designated as thermoelectric module PC25, a module formed such that A/B becomes equal to 3.5 vol % / µm is designated as thermoelectric module PC26, and a module formed such that A/B becomes equal to 3.7 vol % / µm is designated as thermoelectric module PC27.

Further, when maximum temperature difference (ΔTmax) and maximum endothermic quantity (Qmax) are respectively determined in vacuum in a manner as described above by using thermoelectric modules PC21 to PC27 which have been fabricated in a manner as described above, and ACR change rates (change rates of A.C. resistance) serving as index of the reliability (stress relaxation) of the thermoelectric modules PC21 to PC27 are determined in a manner as described above, results as shown in the following Table 16 were obtained.

**Table 16**

| Modules | Resin Material | Filler | (C/4)-B (µm) | A/B (vol%/µm) | ΔTmax (°C) | Qmax (W) | ACR Change Rate (%) |
|---|---|---|---|---|---|---|---|
| PC21 | Epoxy | CNT | 45 | 0. 5 | 71 | 212 | 1. 1 |
| PC22 | Epoxy | CNT | 45 | 0.8 | 70 | 213 | 1. 1 |
| PC23 | Epoxy | CNT | 45 | 1.5 | 71 | 213 | 1.2 |
| PC24 | Epoxy | CNT | 45 | 2. 3 | 72 | 209 | 1.1 |
| PC25 | Epoxy | CNT | 45 | 2.5 | 71 | 208 | 1.4 |
| PC26 | Epoxy | CNT | 45 | 3.5 | 69 | 209 | 1.8 |
| PC27 | Epoxy | CNT | 45 | 3.8 | 67 | 212 | 7.5 |

As apparent from the results of the above Table 16, it is understood that in the case were (C/4) - B is fixed to 45µm, when A/B becomes equal to 3.8 (vol %/µm), the ACR change rate is abruptly elevated so that the reliability of the thermoelectric module PC 27 is lowered. From this fact, in the case where there are used upper substrate 11 and lower substrate 12 in which resin material into which CNT is added as filter is formed of epoxy resin, it is understood that when adjustment of quantity added of CNT as filler is made so that A/B becomes equal to 3.5 (vol %/µm) or less, there can be obtained thermoelectric modules PC21 to PC26 of which reliability has been improved. In this case, in order to maintain insulating property at synthetic resin layer, it is required to add CNT so that the CNT is not included within the range of 5% of total thickness of synthetic resin layer from the surface of the synthetic resin layer.

When the results of the above-described Tables 1 to 16 are synthesized, in the case where any one of alumina powder, aluminum nitride powder, magnesium oxide powder and carbon powder is added in a dispersed manner as filler having satisfactory thermal conductivity (contents volume percentage is assumed as A vol % : A > 0) irrespective of the thermoelectric module configuration (size, composition of thermoelectric element and logarithm of thermoelectric element, etc.), there can be obtained an improved reliability thermoelectric module having the relation expressed as A/B ≤ 3.5 (vol %/µm) and B ≥ 7 (µm) and such that copper layer or layers (total thickness is designated as Cµm) is or are formed on one face or both faces of the synthetic resin layer so that the relation expressed as (C/4) - B ≤ 65 (µm) holds.

It is to be noted that while the example where polyimide resin or epoxy resin is used as synthetic resin material has been described in the above-described embodiments, if aramid resin or BT resin (bismaleimide triazine resin), etc. except for polyimide resin or epoxy resin is used, the effects/advantages similar to the above can be obtained.

Further, while the example using any one of alumina powder, aluminum nitride powder, magnesium oxide powder and carbon powder has been described in the above-described embodiments, filler material is not limited to these materials. If material having satisfactory thermal conductivity is employed, there may be used silicon carbide, or silicon nitride, etc. Further, although only one kind of filler material may be employed, there may be employed a material including two kinds thereof or more in a mixed state. In addition, spherical filler, needle-shaped filler, or mixture thereof as shape of filler may be advantageously used.

While preferred embodiments of the invention have been described and illustrated above, it should be understood that there are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A thermoelectric module substrate comprising: 2008 a synthetic resin layer in which a thermal-conductive filler is dispersed;
and
at least one of a copper metalized layer and a copper layer constituted from a copper plate that is formed on one or both faces of the synthetic resin layer,
wherein contents volume percentage of the filler within the synthetic resin layer is A (vol %), the thickness of the synthetic resin layer is B (µm), and total thickness of the copper layer or the copper metalized layer is C (µm),
(C/4) - B ≤ 65 (µm),
A/B ≤ 3.5 (vol % / µm),
A > 0, C > 50 (µm), and
B ≥ 7 (µm).

2. The thermoelectric module substrate according to claim 1,
wherein the synthetic resin is either polyimide resin or epoxy resin.

3. The thermoelectric module substrate according to claim 1,
wherein the thermal-conductive filler is selected from a group consisting of alumina, aluminum nitride, magnesium oxide and carbon, and at least one kind thereof is added into the synthetic resin layer in a dispersed manner.

4. The thermoelectric module substrate according to claim 3,
wherein in the case where the carbon is graphite or carbon nanotube, the graphite or the carbon nanotube is dispersed in such a manner that the graphite or the carbon nanotube does not exist within the range of 5% of total thickness of the synthetic resin layer from both surfaces of the synthetic resin layer.

5. A thermoelectric module to which a first and second thermoelectric module substrates according to claim 1 are attached, wherein
the first thermoelectric module substrate which is an upper substrate comprises a metallic layer formed on a reverse surface that serves as a wiring pattern for thermoelectric elements,
the second thermoelectric module substrate which is a lower substrate comprises a metallic layer formed on an obverse surface that serves as a wiring pattern for thermoelectric elements, and
the thermoelectric module comprises a plurality of thermoelectric elements which are arranged and fixed and are connected in series between the thermoelectric element wiring patterns of the first and second thermoelectric module substrates.
